# EUROPEAN PATENT SPECIFICATION

(11) **EP 3 071 003 B1**
(45) Date of publication and mention of the grant of the patent: **14.06.2017**
(21) Application number: 15160068.1
(22) Date of filing: 20.03.2015
(51) Int. Cl.: H05K 7/14

(54) **SLIDE RAIL ASSEMBLY**
SCHIENENANORDNUNG
ENSEMBLE DE RAIL DE GLISSEMENT

(43) Date of publication of application: 21.09.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A- 3 904 254
- US-A1- 2014 217 049
- US-A1- 2014 265 786

## Description

### Field of the Invention

The present invention relates to a slide rail assembly and more particularly to a slide rail assembly which includes a first rail, a second rail movably connected to the first rail, and a supporting base for providing additional support for the second rail when the second rail is at an extended position relative to the first rail.

### Background of the Invention

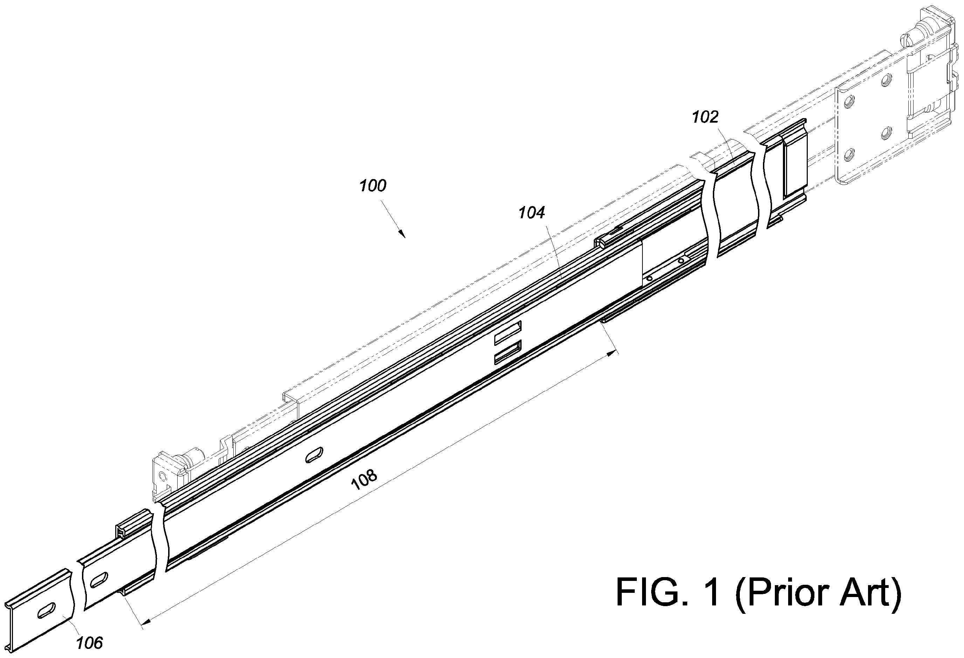

Generally, a slide rail assembly in a rack-based server system serves to mount the chassis of a piece of electronic equipment to a rack. As shown in FIG. 1, a typical slide rail assembly 100 includes a first rail 102, a second rail 104, and a third rail 106. Each of the second rail 104 and the third rail 106 can be displaced relative to the first rail 102 so as to reach an extended position, thereby bringing the slide rail assembly 100 to an extended state. However, when the second rail 104 and the third rail 106 are at their respective extended positions relative to the first rail 102, a certain section 108 of the second rail 104 is left unsupported by the first rail 102. If the third rail 106 is to be mounted with the chassis of some electronic equipment, therefore, the load bearing capacity of the second rail 104 becomes an issue.

US 2014/265786 A1 discloses a slide rail assembly with a first rail and a second rail. The first rail defines a side wall and has a longitudinal channel and the second rail is longitudinally displaceable within the longitudinal channel of the first rail.

US 3,904,254 A discloses a slide rail assembly according to the preamble of claim 1. The slide rail assembly comprises a first outer rail defining a side wall and a longitudinal channel. Further, the slide rail assembly comprises a second rail longitudinally displaceable within the longitudinal channel of the first rail.

### Summary of the Invention

The present invention relates to a slide rail assembly according to claim 1. The slide rail assembly includes a supporting base for supporting a rail of the slide rail assembly.

According to one aspect of the present invention, a slide rail assembly for a chassis of a rack-based server system includes a first rail, a second rail, a bracket base, and a supporting base. The first rail defines a side wall and a longitudinal channel. The second rail is longitudinally displaceable within the longitudinal channel of the first rail. The bracket base is rigidly connected to the sidewall of the first rail. The supporting base is for supporting the second rail and is movably mounted to the bracket base and includes a wall portion and at least one supporting portion transversely connected to the wall portion, wherein the wall portion and the at least one supporting portion jointly define a supporting channel corresponding and aligned to the longitudinal channel of the first rail. The second rail is allowed to displace into the supporting channel while being displaced relative to the first rail from the retracted position to an extended position.

According to another aspect of the present invention, a slide rail assembly includes a first rail, a bracket base, a supporting base, and a second rail. The first rail includes an upper wall, a lower wall, and the sidewall connecting between the upper wall and the lower wall, wherein the upper wall, the lower wall, and the sidewall jointly define a longitudinal channel. The supporting base is movably mounted to the bracket base and includes a wall portion and at least one supporting portion transversely connected to the wall portion, wherein the wall portion and the at least one supporting portion jointly define a supporting channel corresponding to the longitudinal channel of the first rail. The second rail is movably connected to the first rail and can be longitudinally displaced relative to the first rail between the retracted position and the extended position. The second rail extends through the longitudinal channel of the first rail and the supporting channel of the supporting base and is supported by the at least one supporting portion of the supporting base during displacement relative to the first rail from the retracted position to the extended position.

According to still another aspect of the present invention, a slide rail assembly adapted to mount a chassis to a rack is provided, wherein the rack includes a first post and a second post. The slide rail assembly includes a first rail, a bracket base, a supporting base, a second rail, and a third rail. The first rail includes an upper wall, a lower wall, and a sidewall connecting between the upper wall and the lower wall, wherein the upper wall, the lower wall, and the sidewall jointly define a longitudinal channel. The bracket base is mounted to the first post and the second post by a first bracket and a second bracket respectively. The supporting base is movably mounted to the bracket base and includes a wall portion and at least one supporting portion transversely connected to the wall portion, wherein the wall portion and the at least one supporting portion jointly define a supporting channel corresponding to the longitudinal channel of the first rail. The second rail is movably connected to the first rail and can be longitudinally displaced relative to the first rail so as to extend through the longitudinal channel of the first rail and the supporting channel of the supporting base and be supported by the at least one supporting portion of the supporting base. The third rail can be longitudinally displaced relative to the second rail and is mounted with the chassis. Preferably, the chassis includes a first portion and a second portion, the first portion has a greater width than the second portion, and the third rail is mounted to a lateral side of the second portion of the chassis.

In some embodiments of any of the above aspects, the bracket base further includes at least one longitudinal groove, and the slide rail assembly further includes at least one connecting element. Each of the at least one connecting element includes a head and a body connected to the head. The body of each of the at least one connecting element is passed through a corresponding one of the at least one longitudinal groove and is connected to the wall portion of the supporting base such that the head of each of the at least one connecting element is blocked on one side of the bracket base.

In some embodiments of any of the above aspects, the slide rail assembly further includes at least one supporting member corresponding to and mounted to the at least one supporting portion of the supporting base, and the second rail, once displaced into the supporting channel of the supporting base, is in contact with and supported by the at least one supporting member and displaces the supporting base relative to the bracket base by means of the contact.

In some embodiments of any of the above aspects, the supporting base includes a pair of the aforesaid supporting portions, which are transversely connected to one side of the wall portion at two positions respectively, and the supporting channel is defined jointly by the wall portion and the pair of supporting portions. Preferably, the second rail includes an upper wall, a lower wall, and a sidewall connecting between the upper wall and the lower wall, and the upper wall and the lower wall of the second rail correspond to the pair of supporting portions of the supporting base respectively when the second rail has been displaced into the supporting channel of the supporting base. Preferably, the slide rail assembly further includes a pair of supporting members mounted to the pair of supporting portions of the supporting base respectively, and while the second rail extends through the supporting channel of the supporting base, the upper wall and the lower wall of the second rail are in contact with the pair of supporting members respectively and displace the supporting base relative to the bracket base by means of the contact.

One of the advantageous features of applying the present invention is that the supporting base can provide additional support for the second rail when the second rail is at an extended position relative to the first rail.

### Brief Description of the Drawings

FIG. 1 is a perspective view of a conventional slide rail assembly in an extended state in which a certain section of the second rail is left unsupported by the first rail;
FIG. 2 is a perspective view of the slide rail assembly in a first embodiment of the present invention, wherein the slide rail assembly is in an extended state and the second rail is supported by the supporting base;
FIG. 3 is an exploded perspective view of the slide rail assembly in the first embodiment of the present invention;
FIG. 4 shows how the slide rail assembly in the first embodiment of the present invention is used to mount a chassis to a rack, the slide rail assemblies shown being in an extended state;
FIG. 5A shows the slide rail assembly in the first embodiment of the present invention in an extended state, with the third rail mounted to the second portion of a chassis;
FIG. 5B shows the slide rail assembly in the first embodiment of the present invention in a retracted state, and how a chassis mounted to the slide rail assembly is received in a rack;
FIG. 6A shows the slide rail assembly in the first embodiment of the present invention in a retracted state in which the supporting base is at a predetermined position and the second rail, with respect to the first rail, is at a retracted position;
FIG. 6B shows that the second rail of the slide rail assembly in FIG. 6A has been longitudinally displaced relative to the first rail to a first extended position and therefore corresponds to and is supported by a portion of the supporting base;
FIG. 7A shows how the second rail of the slide rail assembly in the first embodiment of the present invention extends through the supporting channel of the supporting base and drives the supporting base to a second supporting position;
FIG. 7B shows that the third rail of the slide rail assembly in FIG. 7A can be further longitudinally displaced relative to the second rail to bring the slide rail assembly to a further extended state;
FIG. 8 is a sectional view taken along line 8-8 in FIG. 6A, showing how the supporting members support the second rail; and
FIG. 9 shows the slide rail assembly in a second embodiment of the present invention.

### Detailed Description of the Invention

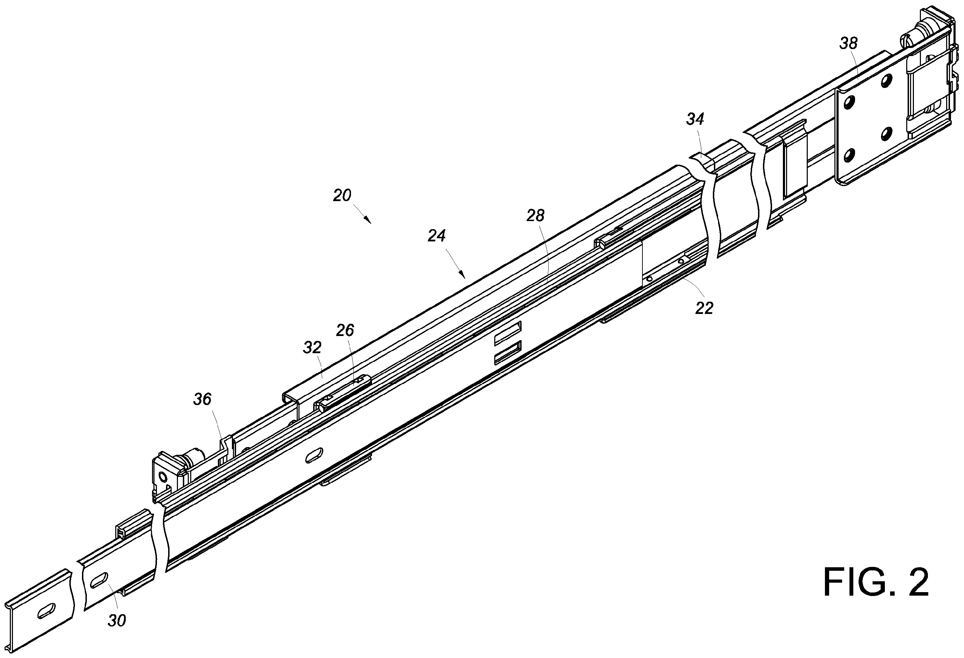

Referring to FIG. 2, the slide rail assembly 20 in the first embodiment of the present invention includes a first rail 22, a bracket base 24, a supporting base 26, a second rail 28, and a third rail 30. The bracket base 24 has a first end portion 32 and a second end portion 34 opposite the first end portion 32. The bracket base 24 is mounted with a first bracket 36 and a second bracket 38, which are adjacent to the first end portion 32 and the second end portion 34 respectively. For example, the first bracket 36 is mounted to the bracket base 24 at a position adjacent to the first end portion 32, and the second bracket 38 is mounted to the bracket base 24 at a position adjacent to the second end portion 34. The first rail 22, the second rail 28, and the third rail 30 are sequentially and longitudinally movably connected together and can be brought to an extended state.

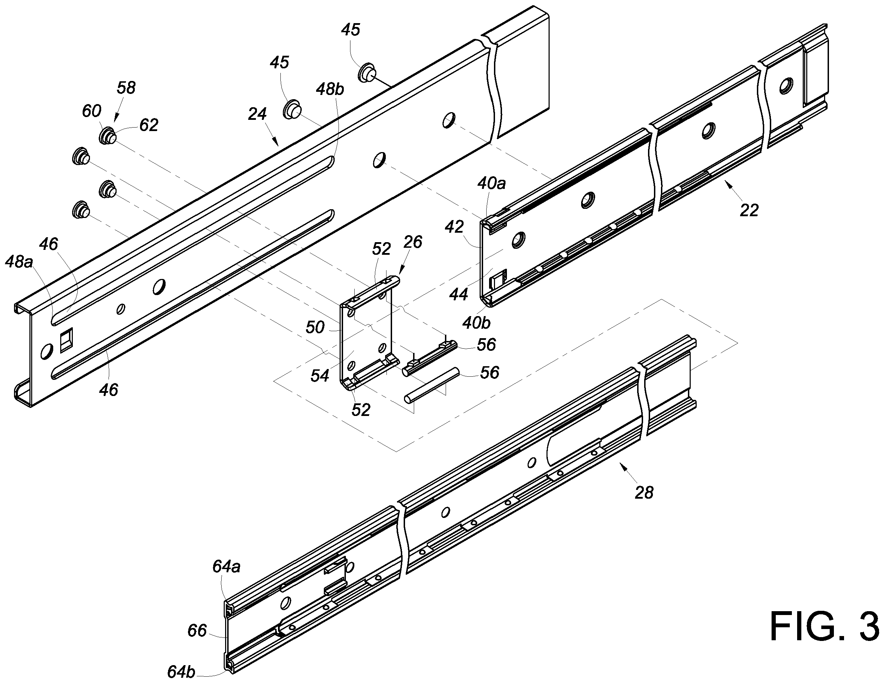

As shown in FIG. 2 and FIG. 3, the first rail 22 includes an upper wall 40a, a lower wall 40b, and a sidewall 42 connecting between the upper wall 40a and the lower wall 40b. The upper wall 40a, the lower wall 40b, and the sidewall 42 jointly define a longitudinal channel 44.

The bracket base 24 is connected to the first rail 22. For instance, the bracket base 24 can be connected to the sidewall 42 of the first rail 22 by riveting, by threaded connection, by soldering, by corresponding engaging features, or the like. In this embodiment, riveting is carried out with rivets 45 by way of example. Alternatively, the bracket base 24 can be integrally formed with the sidewall 42 of the first rail 22 and, in that case, can be viewed as a part of the first rail 22. The present invention imposes no limitations on how the bracket base 24 is connected to the first rail 22. Preferably, the bracket base 24 includes at least one longitudinal groove 46. In this embodiment, two longitudinal grooves 46 are provided by way of example, and each longitudinal groove 46 is defined between a first blocking wall 48a and a second blocking wall 48b.

The supporting base 26 is movably mounted to the bracket base 24. The supporting base 26 includes a wall portion 50 and at least one supporting portion 52 transversely connected to the wall portion 50. Here, the supporting base 26 includes a pair of supporting portions 52 by way of example. The pair of supporting portions 52 are transversely connected to the same side of the wall portion 50 at two positions (e.g., an upper position and a lower position) respectively such that the supporting portions 52 correspond to each other. The wall portion 50 and the pair of supporting portions 52 jointly define a supporting channel 54 which corresponds to the longitudinal channel 44 of the first rail 22, and the second rail 28 is allowed to displace into the supporting channel 54. Preferably, a pair of supporting members 56 are mounted to the pair of supporting portions 52 of the supporting base 26 respectively. In practice, each of the supporting members 56 and each of the supporting portions 52 may be provided with corresponding structural features (e.g., corresponding projections and holes) to facilitate assembly, or at least one additional connecting element is used for the assembly. The present invention has no limitations in this regard. The supporting base 26 is movably mounted to the bracket base 24 by at least one connecting element 58. For example, each longitudinal groove 46 is mounted with two connecting elements 58, and each connecting element 58 includes a head 60 and a body 62 connected to the head 60, with the head 60 larger than the body 62 in diameter. The body 62 of each connecting element 58 is passed through the corresponding longitudinal groove 46 of the bracket base 24 and connected to the wall portion 50 of the supporting base 26 such that the head 60 of each connecting element 58 is blocked on one side of the bracket base 24. The foregoing arrangement allows the supporting base 26 to be displaced relative to the bracket base 24 within a range defined by the length of the longitudinal grooves 46.

The second rail 28 is movably connected to the first rail 22 and is located in the longitudinal channel 44. The second rail 28 includes an upper wall 64a, a lower wall 64b, and a sidewall 66 connecting between the upper wall 64a and the lower wall 64b.

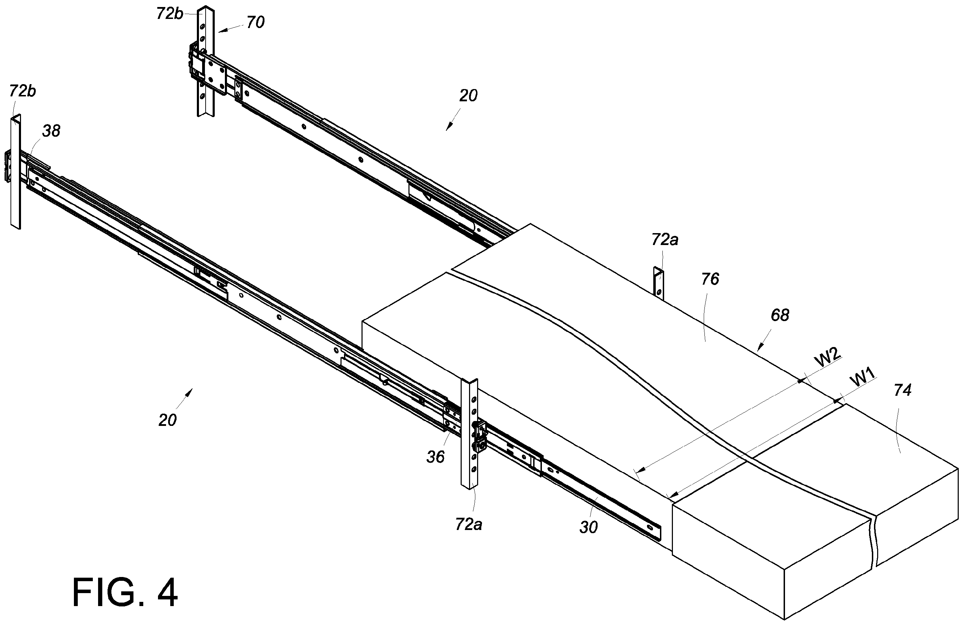

FIG. 4 shows how a chassis 68 is mounted to a rack 70 via a pair of slide rail assemblies 20. The rack 70 includes two pairs of posts, e.g., two corresponding first posts 72a and two corresponding second posts 72b. Each slide rail assembly 20 has two portions (e.g., a front portion and a rear portion) mounted to one first post 72a and one second post 72b of the rack 70 via the first bracket 36 and the second bracket 38 respectively in order to mount the chassis 68 to the rack 70. More specifically, the chassis 68 is mounted to the third rails 30 of the slide rail assemblies 20. In this embodiment, the chassis 68 is a generally T-shaped chassis. For example, the chassis 68 includes a first portion 74 and a second portion 76. The first portion 74 has a first width W1, and the second portion 76 has a second width W2, wherein the first width W1 is greater than the second width W2.

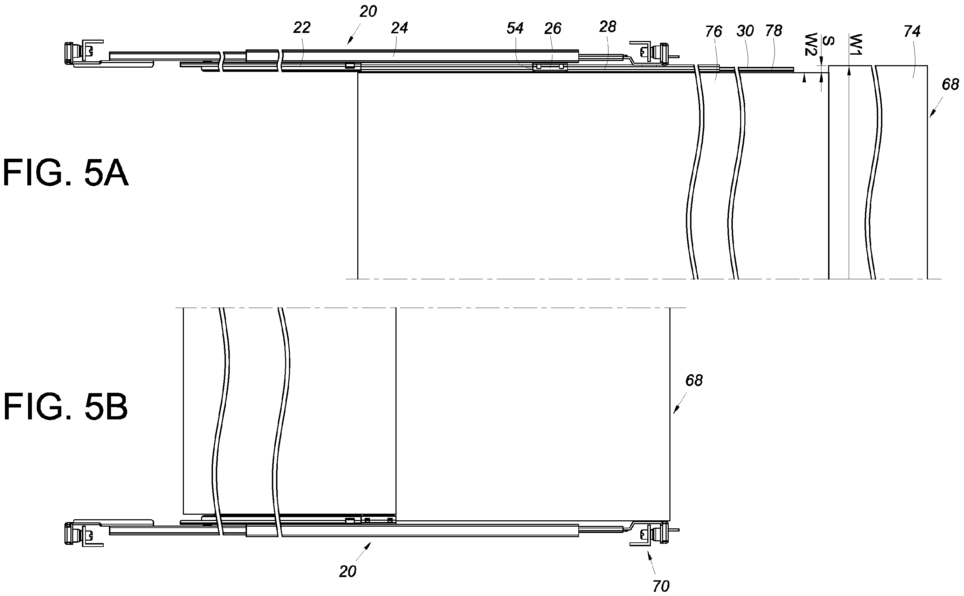

In FIG. 5A, the slide rail assembly 20 is in an extended state. As the width W1 of the first portion 74 of the chassis 68 is greater than the width W2 of the second portion 76 of the chassis 68, the first portion 74 has an extra width S in comparison with the second portion 76. Because of that, the third rail 30 of the slide rail assembly 20 cannot but be mounted to a lateral side 78 of only the second portion 76 of the chassis 68. When the slide rail assembly 20 is in the extended state, therefore, it is all the more necessary that the weight of the chassis 68 acting on the third rail 30 be shared by other components of the slide rail assembly 20, such as the second rail 28. In the course in which the second rail 28 is pulled out relative to the first rail 22 toward an extended position, the second rail 28 extends through the supporting channel 54 of the supporting base 26 in order for the supporting base 26, which is movably connected to the bracket base 24, to provide additional support to the second rail 28, thereby enabling the second rail 28 to hold out against the weight of the chassis 68 acting on the third rail 30. In FIG. 5B, the slide rail assembly 20 is in a retracted state in which the entire chassis 68 is received in the rack 70.

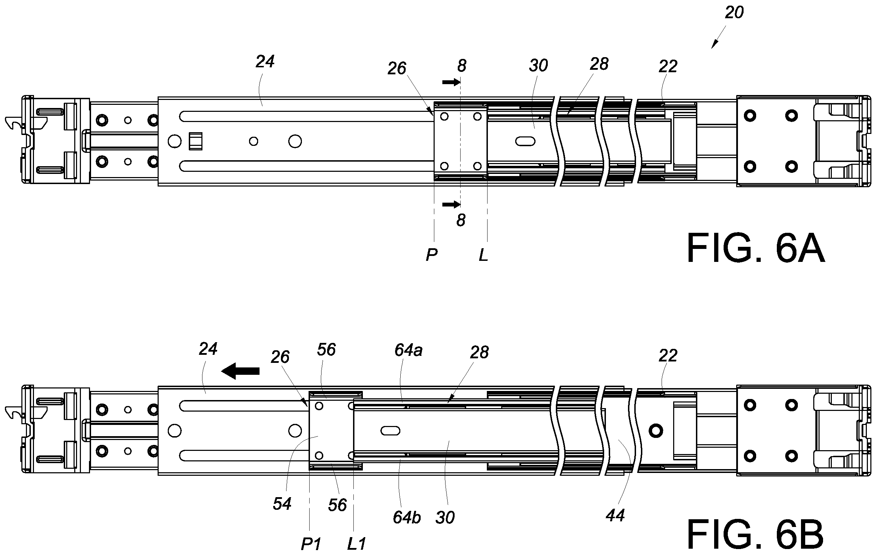

The slide rail assembly 20 in FIG. 6A is in the retracted state, meaning the second rail 28 and the third rail 30 have both been retracted with respect to the first rail 22. In this state, the supporting base 26 can be adjusted relative to the bracket base 24 to a predetermined position P if necessary, and the second rail 28 can be located at a retracted position L relative to the first rail 22.

Referring to FIG. 6B, the third rail 30 is pulled out relative to the first rail 22 in an extending direction (indicated by the arrow) such that the second rail 28 is driven by the third rail 30 and hence longitudinally displaced relative to the first rail 22 from the retracted position L to a first extended position L1. More specifically, in the course in which the second rail 28 is displaced, a portion of the second rail 28 juts out of the longitudinal channel 44 of the first rail 22 and is longitudinally displaced relative to the first rail 22 into the supporting channel 54 of the supporting base 26. Consequently, the upper wall 64a and the lower wall 64b of the second rail 28 correspond to, for example, the pair of supporting members 56 of the supporting base 26 respectively. In addition, by means of friction, the second rail 28 drives the supporting base 26 from the predetermined position P to a first supporting position P1 relative to the bracket base 24, allowing a portion of each of the supporting members 56 to support the corresponding one of the upper wall 64a and the lower wall 64b of the second rail 28. It is worth mentioning that the supporting members 56 in use can be so chosen that they have the appropriate thicknesses for dealing with or compensating for support errors, if any. The goal is to ensure that each supporting member 56 can support the second rail 28 effectively.

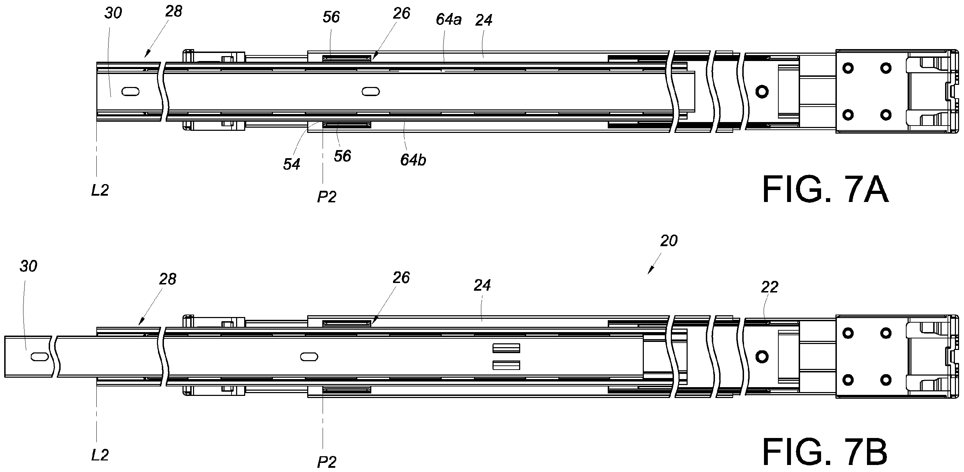

Referring to FIG. 7A, when the second rail 28 is further driven by the third rail 30 to a second extended position L2, the second rail 28 not only extends through the supporting channel 54 of the supporting base 26, but further drives the supporting base 26, by friction, from the first supporting position P1 to a second supporting position P2 relative to the bracket base 24, in order for the pair of supporting members 56 of the supporting base 26 to support, in their entirety, the upper wall 64a and the lower wall 64b of the second rail 28 respectively.

Referring to FIG. 7B, when the second rail 28 is at the second extended position L2 (e.g., when the second rail 28 has been extended to the greatest extent possible), the third rail 30 can be further pulled out and hence longitudinally displaced relative to the second rail 28, thereby bringing the slide rail assembly 20 to a further extended state.

It can be known from the above that, once displaced relative to the first rail 22 into the supporting channel 54 of the supporting base 26, the second rail 28 is supported by the supporting base 26. Therefore, if the third rail 30 is mounted with the chassis 68 shown in FIG. 4, the supporting base 26 will be able to support the second rail 28 and allow the second rail 28 to effectively share the weight of the chassis 68. It should be pointed out that, although the supporting base 26 can be frictionally driven into displacement by the second rail 28 while the second rail 28 is being pulled out relative to the first rail 22 toward an extended position, the slide rail assembly 20 can be so designed that the second rail 28 directly passes through the supporting channel 54 of the supporting base 26, and that the supporting base 26 can be manually adjusted to a proper supporting position in order to support the second rail 28 and thereby satisfy the practical need for support.

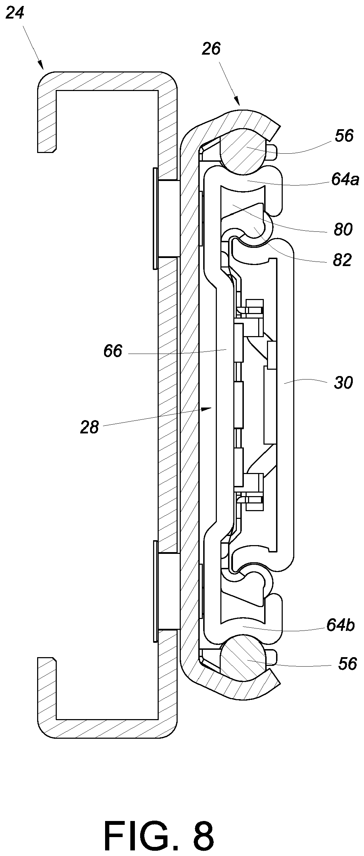

FIG. 8 further illustrates the arrangement of the bracket base 24, the supporting base 26, and the second rail 28. More specifically, the upper wall 64a, the lower wall 64b, and the sidewall 66 of the second rail 28 jointly define a longitudinal channel 80 in which the third rail 30 is mounted. For example, the longitudinal channel 80 is mounted therein with a slide facilitating member 82 to facilitate displacement of the third rail 30 relative to the second rail 28. The supporting base 26 is movably mounted to the bracket base 24, and the pair of supporting members 56 of the supporting base 26 can be brought into contact with the upper wall 64a and the lower wall 64b of the second rail 28 respectively so as to support the second rail 28.

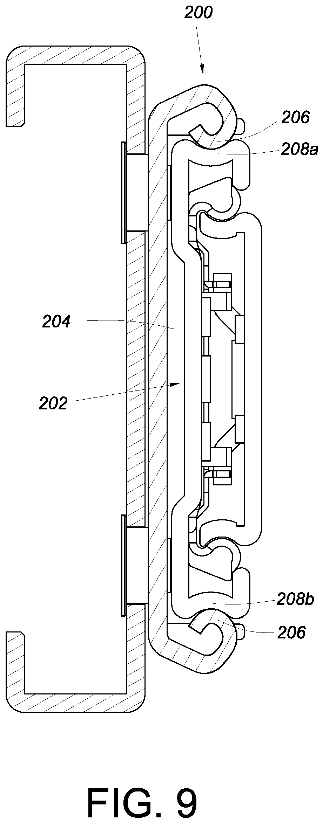

Please refer to FIG. 9 for the slide rail assembly in the second embodiment of the present invention, with particular attention to the supporting base 200. The supporting base 200 in this embodiment is different from its counterpart in the first embodiment generally in that, when the second rail 202 passes through the supporting channel 204 of the supporting base 200, the pair of supporting portions 206 of the supporting base 200 support the second rail 202 through respective direct contact with the upper wall 208a and the lower wall 208b of the second rail 202.

While the present invention has been disclosed through the foregoing preferred embodiments, the embodiments described above are not intended to be restrictive of the present invention. The scope of patent protection sought by the applicant is defined by the appended claims

## Claims

1. A slide rail assembly (20) for a chassis (68) of a rack-based server system, comprising:
a first rail (22) defining a side wall (42) and a longitudinal channel (44);
a second rail (28, 202) movably connected to the first rail (22) and longitudinally displaceable within the longitudinal channel (44) of the first rail (22);
**characterized in, that** the slide rail assembly (20) further comprises a bracket base (24) rigidly connected to the sidewall (42) of the first rail (22); and
a supporting base (26, 200) for supporting the second rail (28, 202) and movably mounted to the bracket base (24), the supporting base (26, 200) including a wall portion (50) and at least one supporting portion (52, 206) transversely connected to the wall portion (50), wherein the wall portion (50) and the at least one supporting portion (52, 206) jointly define a supporting channel (54, 204) corresponding and aligned to the longitudinal channel (44) of the first rail (22), and the second rail (28, 202) is allowed to displace into the supporting channel (54, 204) while being displaced relative to the first rail (22) from a retracted position (L) to an extended position (L1, L2).

2. The slide rail assembly (20) as claimed in claim 1, wherein the bracket base (24) further includes at least one longitudinal groove (46), and the slide rail assembly (20) further includes at least one connecting element (58), each of the at least one connecting element (58) including a head (60) and a body (62) connected to the head (60), the body (62) of each of the at least one connecting element (58) extending through a corresponding one of the at least one longitudinal groove (46) and being connected to the wall portion (50) of the supporting base (26, 200) such that the head (60) of each of the at least one connecting element (58) is blocked on one side of the bracket base (24).

3. The slide rail assembly (20) as claimed in claim 1, wherein the supporting base (26, 200) includes a pair of said supporting portions (52, 206), which are transversely connected to one side of the wall portion (50) at two positions respectively, and the wall portion (50) and the pair of supporting portions (52, 206) jointly define the supporting channel (54, 204).

4. The slide rail assembly (20) as claimed in claim 3, wherein the second rail (28, 202) includes an upper wall (64a, 208a), a lower wall (64b, 208b), and a sidewall (66) connecting between the upper wall (64a, 208a) and the lower wall (64b, 208b), and the upper wall (64a, 208a) and the lower wall (64b, 208b) of the second rail (28, 202) correspond to the pair of supporting portions (52, 206) of the supporting base (26, 200) respectively when the second rail (28, 202) has been displaced into the supporting channel (54, 204) of the supporting base (26, 200).

5. The slide rail assembly (20) as claimed in claim 1, further comprising at least one supporting member (56) corresponding to and mounted to the at least one supporting portion (52) of the supporting base (26), wherein the second rail (28), once displaced into the supporting channel (54) of the supporting base (26), is in contact with and supported by the at least one supporting member (56) and, through said contact, drives the supporting base (26) into displacement relative to the bracket base (24).

6. The slide rail assembly (20) as claimed in claim 1, wherein the first rail (22) includes an upper wall (40a), a lower wall (40b), and the sidewall (42) connecting between the upper wall (40a) and the lower wall (40b), the upper wall (40a), the lower wall (40b), and the sidewall (42) jointly defining the longitudinal channel (44); the second rail (28, 202) is longitudinally displaceable relative to the first rail (22) between the retracted position (L) and the extended position (L1, L2); and the second rail (28, 202) extends through the longitudinal channel (44) of the first rail (22) and the supporting channel (54, 204) of the supporting base (26, 200) and is supported by the at least one supporting portion (52, 206) of the supporting base (26, 200) while being displaced relative to the first rail (22) from the retracted position (L) to the extended position (L1, L2).

7. The slide rail assembly (20) as claimed in claim 6, wherein the supporting base (26, 200) includes a pair of said supporting portions (52, 206), which are transversely connected to one side of the wall portion (50) at two positions respectively; the wall portion (50) and the pair of supporting portions (52, 206) jointly define the supporting channel (54, 204); the second rail (28, 202) includes an upper wall (64a, 208a), a lower wall (64b, 208b), and a sidewall (66) connecting between the upper wall (64a, 208a) and the lower wall (64b, 208b); and the upper wall (64a, 208a) and the lower wall (64b, 208b) of the second rail (28, 202) correspond to the pair of supporting portions (52, 206) of the supporting base (26, 200) respectively while the second rail (28, 202) extends through the supporting channel (54, 204) of the supporting base (26, 200).

8. The slide rail assembly (20) as claimed in claim 7, further comprising a pair of supporting members (56) mounted to the pair of supporting portions (52) of the supporting base (26) respectively, wherein while the second rail (28) extends through the supporting channel (54) of the supporting base (26), the upper wall (64a) and the lower wall (64b) of the second rail (28) are in contact with the pair of supporting members (56) respectively and, through said contact, drive the supporting base (26) into displacement relative to the bracket base (24).

9. The slide rail assembly (20) as claimed in 1, wherein the slide rail assembly (20) is adapted to mount the chassis (68) to a rack (70), the rack (70) including a first post (72a) and a second post (72b); the first rail includes an upper wall (40a), a lower wall (40b), and the sidewall (42) connecting between the upper wall (40a) and the lower wall (40b), the upper wall (40a), the lower wall (40b), and the sidewall (42) jointly defining the longitudinal channel (44); the bracket base (24) is mounted to the first post (72a) and the second post (72b) by a first bracket (36) and a second bracket (38) respectively; the second rail (28, 202) is allowed to extend through the longitudinal channel (44) of the first rail (22) and the supporting channel (54, 204) of the supporting base (26, 200) and be supported by the at least one supporting portion (52, 206) of the supporting base (26, 200), and the slide rail assembly (20) further comprises a third rail (30), the third rail (30) being longitudinally displaceable relative to the second rail (28, 202) and mounted with the chassis (68).

10. The slide rail assembly (20) as claimed in claim 9, wherein the chassis (68) includes a first portion (74) and a second portion (76), the first portion (74) has a greater width than the second portion (76), and the third rail (30) is mounted to a lateral side (78) of the second portion (76) of the chassis (68)

## Patentansprüche

1. Eine Laufschienenmontage (20) für ein Fahrgestell (68) eines auf einem Gestell basierten Serversystems, umfassend:
eine erste Schiene (22), die mit einer Seitenwand (42) und mit einem Längskanal (44) gebildet ist;
eine zweite Schiene (28, 202) die beweglich an der ersten Schiene befestigt und im Längskanal (44) der ersten Schiene (22) der Länge nach verschiebbar ist;
**dadurch gekennzeichnet, dass** die Laufschienenmontage (20) weiter eine Halterbasis (24) umfaßt, die fest an der Seitenwand (42) der ersten Schiene (22) befestigt ist; und
eine Stützbasis (26, 200) zum Tragen der zweiten Schiene (28, 202) und die beweglich an der Halterbasis (24) montiert ist; die Stützbasis (26, 200) aus einem Wandabschnitt (50) und aus mindestens einem Stützteil (52, 206), der quer am Wandabschnitt (50) befestigt ist, besteht, wobei der Wandabschnitt (50) und der mindestens eine Stützteil (52, 206) entsprechend dem Längskanal (44) der ersten Schiene (22) zusammen einen Stützkanal (54, 204) bilden, der nach diesem Längskanal (44) der ersten Schiene (22) ausgerichtet ist; die zweite Schiene (28, 202) im Stützkanal (54, 204) verschoben werden kann, wobei diese in der ersten Schiene (22) von einer eingezogenen Position (L) in eine ausgezogene Position (L1, L2) verschoben werden kann.

2. Die Laufschienenmontage (20) nach Anspruch 1, wobei die Halterbasis (24) weiter mindestens eine Längsrille (46) aufweist; die Laufschienenmontage (20) weiter aus mindestens einem Verbindungselement (58) besteht; jedes des mindestens einen Verbindungselements (58) einen Kopfteil (60) und einen Körper (62), der am Kopfteil (60) befestigt ist, aufweist; der Körper (62) eines jeden des mindestens einen Verbindungselements (58) durch eine jeweilige der mindestens einen Längsrillen (46) ragt und so am Wandabschnitt (50) der Stützbasis (26, 200) befestigt ist, dass der Kopfteil (60) eines jeden des mindestens einen Verbindungselements (58) auf einer Seite der Halterbasis (24) blockiert ist.

3. Die Laufschienenmontage (20) nach Anspruch 1, wobei die Stützbasis (26, 200) aus einem Paar Stützteile (52, 206) besteht, die quer auf einer Seite des Wandabschnitts (50) je in eine der Positionen befestigt sind; der Wandabschnitt (50) und das Paar Stützteile (52, 206) zusammen den Stützkanal (54, 204) bilden.

4. Die Laufschienenmontage (20) nach Anspruch 3, wobei die zweite Schiene (28, 202) eine obere Wand (64a, 208a), eine untere Wand (64b, 208b) und eine Seitenwand (66) aufweist und dabei diese Seitenwand (66) zwischen der oberen Wand (64a, 208a) und der unteren Wand (64b, 208b) befestigt ist; die obere Wand (64a, 208a) und die untere Wand (64b, 208b) der zweiten Schiene (28, 202) mit dem Paar Stützteile (52, 206) der Stützbasis (26, 200) übereinstimmt, wenn die zweite Schiene (28, 202) in den Stützkanal (54, 204) der Stützbasis (26, 200) verschoben wurde.

5. Die Laufschienenmontage (20) nach Anspruch 1, weiter umfassend mindestens ein Trageglied (56) in Übereinstimmung mit mindestens einem Stützteil (52) der Stützbasis (26) und an diesem montiert, während die zweite Schiene (28) nach dem Verschieben in den Stützkanal (54) der Stützbasis (26) mit dem mindestens einen Trageglied (56) in Berührung kommt und von diesem getragen wird; durch diese Berührung die Stützbasis (26) zum Ausrücken aus der Halterbasis (24) angetrieben wird.

6. Die Laufschienenmontage (20) nach Anspruch 1, wobei die erste Schiene (22) aus einer oberen Wand (40a), einer unteren Wand (40b) und aus der Seitenwand (42) besteht; diese Seitenwand (42) zwischen der oberen Wand (40a) und der unteren Wand (40b) befestigt ist; die obere Wand (40a), die untere Wand (40b) und die Seitenwand (42) zusammen den Längskanal (44) bilden; die zweite Schiene (28, 202) der Länge nach in der ersten Schiene (22) zwischen der eingezogenen Position (L) und der ausgezogenen Position (L1, L2) verschiebbar ist; die zweite Schiene (28, 202) durch den Längskanal (44) der ersten Schiene (22) und den Stützkanal (54, 204) der Stützbasis (26, 200) ragt und beim Verschieben in der ersten Schiene (22) von der eingezogenen Position (L) in die ausgezogene Position (L1, L2) von dem mindestens einen Stützteil (52, 206) der Stützbasis (26, 200) getragen wird.

7. Die Laufschienenmontage (20) nach Anspruch 6, wobei die Stützbasis (26, 200) aus einem Paar Stützteile (52, 206) besteht, die quer auf einer Seite des Wandabschnitts (50) in je eine der Positionen befestigt sind; der Wandabschnitt (50) und das Paar Stützteile (52, 206) zusammen den Stützkanal (54, 204) bilden; die zweite Schiene (28, 202) mit einer oberen Wand (64a, 208a), einer unteren Wand (64b, 208b) und mit einer Seitenwand (66) gebildet ist, wobei die Seitenwand (66) zwischen der oberen Wand (64a, 208a) und der unteren Wand (64b, 208b) befestigt ist; die obere Wand (64a, 208a) und die untere Wand (64b, 208b) der zweiten Schiene (28, 202) je mit dem Paar Stützteile (52, 206) der Stützbasis (26, 200) übereinstimmen, während die zweite Schiene (28, 202) durch den Stützkanal (54, 204) der Stützbasis (26, 200) ragt.

8. Die Laufschienenmontage (20) nach Anspruch 7, weiter umfassend ein Paar Trageglieder (56), die je am Paar Stützteile (52) der Stützbasis (26) montiert sind; die zweite Schiene (28) durch den Stützkanal (54) der Stützbasis (26) ragt; die obere Wand (64a) und die untere Wand (64b) der zweiten Schiene (28) je mit dem Paar Trageglieder (56) in Berührung sind; durch diese Berührung die Stützbasis (26) relativ zur Halterbasis (24) verschoben wird.

9. The Laufschienenmontage (20) nach Anspruch 1, wobei mit der Laufschienenmontage (20) das Fahrgestell (68) an ein Gestell (70) montiert wird; das Gestell (70) aus einer ersten Stange (72a) und aus einer zweiten Stange (72b) besteht; die erste Schiene mit einer oberen Wand (40a), einer unteren Wand (40b) gebildet ist, während die Seitenwand (42) zwischen der oberen Wand (40a) und der unteren Wand (40b) befestigt ist; die obere Wand (40a), die untere Wand (40b) und die Seitenwand (42) zusammen den Längskanal (44) bilden; die Halterbasis (24) mit einem ersten Halter (36) bzw. mit einem zweiten Halter (38) an der ersten Stange (72a) und an der zweiten Stange (72b) montiert ist; die zweite Schiene (28, 202) sich durch den Längskanal (44) der ersten Schiene (22) und den Stützkanal (54, 204) der Stützbasis (26, 200) erstrecken kann und von dem mindestens einen Stützteil (52, 206) der Stützbasis (26, 200) getragen wird; die Laufschienenmontage (20) weiter eine dritte Schiene (30) umfaßt; die dritte Schiene (30) der Länge nach in der zweiten Schiene (28, 202) verschiebbar und mit dem Fahrgestell (68) montiert ist.

10. Die Laufschienenmontage (20) nach Anspruch 9, wobei das Fahrgestell (68) aus einem ersten Teil (74) und aus einem zweiten Teil (76) besteht; der erste Teil (74) eine größere Breite als der zweite Teil (76) aufweist; die dritte Schiene (30) an eine laterale Seite (78) des zweiten Teils (76) des Fahrgestells (68) montiert ist.

## Revendications

1. Ensemble de glissières (20) pour un châssis (68) d'un système de serveur basé sur un rack, **caractérisé par le fait qu'**il comprend :
un premier rail (22) définissant une paroi latérale (42) et un canal longitudinal (44) ;
un deuxième rail (28, 202) raccordé de manière mobile au premier rail et déplaçable longitudinalement dans le canal longitudinal (44) du premier rail (22) ;
caractérisé en que l'ensemble de glissières (20) comprend en outre une base de support (24) raccordée de manière rigide à la paroi latérale (42) du premier rail (22) ; et
une base de soutien (26, 200) pour soutenir le deuxième rail (28, 202) et assemblée de manière mobile à la base de support (24), la base de soutien (26, 200) comprenant une partie de paroi (50) et au moins une partie de soutien (52, 206) raccordée de manière transversale à la partie de paroi (50), la partie de paroi (50) et la ou les parties de soutien (52, 206) définissent conjointement un canal de support (54, 204) correspondant et aligné sur le canal longitudinal (44) du premier rail (22), et le deuxième rail (28, 202) est autorisé à se déplacer dans le canal de support (54, 204) tout en étant déplacé par rapport au premier rail (22) à partir d'une position rétractée (L) jusqu'à une position déployée (L1, L2).

2. Ensemble de glissières (20) selon la revendication 1, **caractérisé par le fait que** la base de support (24) comprend en outre au moins une rainure longitudinale (46), et l'ensemble de glissières (20) comprend en outre au moins un élément de raccordement (58), le ou les éléments de raccordement (58) comprenant chacun une tête (60) et un corps (62) raccordé à la tête (60), le corps (62) du ou de chacun des éléments de raccordement (58) se déployant à travers la ou l'une des rainures longitudinales correspondantes (46) et étant raccordé à la partie de paroi (50) de la base de soutien (26, 200) de sorte que la tête (60) du ou de chacun des éléments de raccordement (58) est bloquée sur un côté de la base de support (24).

3. Ensemble de glissières (20) selon la revendication 1, **caractérisé par le fait que** la base de soutien (26, 200) comprend une paire desdites parties de soutien (52, 206), qui sont raccordées de manière transversale à un côté de la partie de paroi (50) à deux positions respectivement, et la partie de paroi (50) et la paire des parties de soutien (52, 206) définissent conjointement le canal de support (54, 204).

4. Ensemble de glissières (20) selon la revendication 3, **caractérisé par le fait que** le deuxième rail (28, 202) comprend une paroi supérieure (64a, 208a), une paroi inférieure (64b, 208b), et une paroi latérale (66) reliant la paroi supérieure (64a, 208a) et la paroi inférieure (64b, 208b), et la paroi supérieure (64a, 208a) et la paroi inférieure (64b, 208b) du deuxième rail (28, 202) correspondent à la paire des parties de soutien (52, 206) de la base de soutien (26, 200) respectivement lorsque le deuxième rail (28, 202) a été déplacé dans le canal de support (54, 204) de la base de soutien (26, 200).

5. Ensemble de glissières (20) selon la revendication 1, **caractérisé par le fait qu'**il comprend en outre au moins un élément de soutien (56) correspondant à et monté sur la ou les parties de soutien (52) de la base de soutien (26), le deuxième rail (28), une fois déplacé dans le canal de support (54) de la base de soutien (26), est en contact avec et soutenu par le ou les éléments de soutien (56) et, à travers ledit contact, entraîne la base de soutien (26) à se déplacer par rapport à la base de support (24).

6. Ensemble de glissières (20) selon la revendication 1, **caractérisé par le fait que** le premier rail (22) comprend une paroi supérieure (40a), une paroi inférieure (40b), et la paroi latérale (42) reliant la paroi supérieure (40a) et la paroi inférieure (40b), la paroi supérieure (40a), la paroi inférieure (40b), et la paroi latérale (42) définissant conjointement le canal longitudinal (44) ; le deuxième rail (28, 202) est déplaçable longitudinalement par rapport au premier rail (22) entre la position rétractée (L) et la position déployée (L1, L2) ; et le deuxième rail (28, 202) se déploie à travers le canal longitudinal (44) du premier rail (22) et le canal de support (54, 204) de la base de soutien (26, 200) et est soutenu par la ou les parties de soutien (52, 206) de la base de soutien (26, 200) tout en étant déplacé par rapport au premier rail (22) à partir de la position rétractée (L) jusqu'à la position déployée (L1, L2).

7. Ensemble de glissières (20) selon la revendication 6, **caractérisé par le fait que** la base de soutien (26, 200) comprend une paire desdites parties de soutien (52, 206), qui sont raccordées de manière transversale à un côté de la partie de paroi (50) à deux positions respectivement ; la partie de paroi (50) et la paire des parties de soutien (52, 206) définissent conjointement le canal de support (54, 204) ; le deuxième rail (28, 202) comprend une paroi supérieure (64a, 208a), une paroi inférieure (64b, 208b), et une paroi latérale (66) reliant la paroi supérieure (64a, 208a) et la paroi inférieure (64b, 208b) ; et la paroi supérieure (64a, 208a) et la paroi inférieure (64b, 208b) du deuxième rail (28, 202) correspondent à la paire des parties de soutien (52, 206) de la base de soutien (26, 200) respectivement alors que le deuxième rail (28, 202) se déploie à travers le canal de support (54, 204) de la base de soutien (26, 200).

8. Ensemble de glissières (20) selon la revendication 7, **caractérisé par le fait qu'**il comprend en outre une paire d'éléments de soutien (56) assemblés sur la paire des parties de soutien (52) de la base de soutien (26) respectivement, alors que le deuxième rail (28) se déploie à travers le canal de support (54) de la base de soutien (26), la paroi supérieure (64a) et la paroi inférieure (64b) du deuxième rail (28) sont en contact avec la paire d'éléments de soutien (56) respectivement et, à travers ledit contact, entraîne la base de soutien (26) à se déplacer par rapport à la base de support (24).

9. Ensemble de glissières (20) tel revendiqué en 1, **caractérisé par le fait que** l'ensemble de glissières (20) est adapté pour assembler le châssis (68) à un rack (70), le rack (70) comprenant un premier montant (72a) et un second montant (72b) ; le premier rail comprend une paroi supérieure (40a), une paroi inférieure (40b), et la paroi latérale (42) reliant la paroi supérieure (40a) et la paroi inférieure (40b), la paroi supérieure (40a), la paroi inférieure (40b), et la paroi latérale (42) définissant conjointement le canal longitudinal (44) ; la base de support (24) est assemblée sur le premier montant (72a) et le second montant (72b) par un premier support (36) et un second support (38) respectivement ; le deuxième rail (28, 202) est autorisé à se déployer à travers le canal longitudinal (44) du premier rail (22) et le canal de support (54, 204) de la base de soutien (26, 200) et être soutenu par la ou les parties de soutien (52, 206) de la base de soutien (26, 200), et l'ensemble de glissières (20) comprend en outre un troisième rail (30), le troisième rail (30) étant déplaçable longitudinalement par rapport au deuxième rail (28, 202) et assemblé avec le châssis (68).

10. Ensemble de glissières (20) selon la revendication 9, **caractérisé par le fait que** le châssis (68) comprend une première partie (74) et une seconde partie (76), la première partie (74) a une plus grande largeur que la seconde partie (76), et le troisième rail (30) est assemblé sur un côté latéral (78) de la seconde partie (76) du châssis (68).
